# EUROPEAN PATENT SPECIFICATION

(11) **EP 3 707 831 B1**
(45) Date of publication and mention of the grant of the patent: **23.08.2023**
(21) Application number: 17930646.9
(22) Date of filing: 06.11.2017
(51) Int. Cl.: H04B 7/155, H04B 10/079, H04B 10/2513, H04B 10/2575, H04B 1/04, H04N 21/61

(54) **AN ARRANGEMENT FOR CATV NETWORK SEGMENTATION**
ANORDNUNG FÜR CATV-NETZWERKSEGMENTIERUNG
CONFIGURATION DE SEGMENTATION DE RÉSEAU CATV

(43) Date of publication of application: 16.09.2020
(73) Proprietor: Teleste Oyj, 20660 Littoinen (FI)
(72) Inventor: MÄKI, Kari, 20320 Turku (FI); KUUSISTO, Sami, 20400 Turku (FI); HALEN, Sami, 20780 Kaarina (FI); FAGERLUND, Perttu, 20540 Turku (FI)
(74) Representative: Berggren Oy
(86) International application number: PCT/FI2017/050762
(87) International publication number: WO 2019/086749

(56) References cited:
- EP-A2- 1 936 977
- US-A1- 2014 282 802
- US-A1- 2014 282 802
- US-A1- 2015 046 964
- US-A1- 2015 049 822
- US-A1- 2015 049 822

## Description

### Field of the invention

The invention relates to cable television (CATV) networks, and especially to network segmentation.

### Background of the invention

CATV networks may be implemented with various techniques and network topologies, but currently most cable television networks are implemented as so-called HFC networks (Hybrid Fiber Coax), i.e. as combinations of a fibre network and a coaxial cable network. Data Over Cable Service interface Specification (DOCSIS) is a CATV standard providing specifications for high-bandwidth data transfer in an existing CATV system. The latest version DOCSIS 3.1 enables the cable network operators to maximize both the downstream and upstream data throughput using the existing HFC networks.

One issue relating to the introduction of DOCSIS 3.1 is the concept of Distributed CCAP Architecture (DCA), where some features of the headend are distributed to the network elements closer to the customers, such as optical nodes and broadband amplifiers. DOCSIS 3.1 specifies at least three distributed network units, i.e. a Remote PHY Device (RPD), a Remote-MACPHY Device (RMD) and Full Duplex (FDX) Node.

The introduction of RPD/RMD or FDX units into the network elements enables to use digital predistortion (DPD) algorithms also in said network elements. DPD provides means for improving the linearity of radio transmitter amplifiers, wherein non-linearity of the amplifier is cancelled by applying a predistortion (i.e. inverse distortion) into the input of the amplifier. Since the non-linearity of the amplifier typically varies depending on the operation mode, a sampling signal from the output of the amplifier is used for adjusting the level of DPD.

However, providing a separate sampling signal to the RPD/RMD or FDX for adjusting the level of DPD causes loss in signal sampling and decreases the output level of the amplifier.

US 2014/282802 discloses a method for delivering CATV content over a fiber network from a transmitter by compensating for optical dispersion over the fiber optic network. The headend transmits a first message along a transmission line to CCAP device, which receives a second message with content based on the first message. This indicates that the head end operates in a first mode for low data rate transmission. A processor of the CCAP device automatically compensates for the amount of dispersion along length of the line based on the second message.

US 2015/049822 discloses a method for using a signal to generate a pilot tone to modulate the bias point of CATV amplifier. The pilot tone may be generated in a CATV headend and downstream amplifiers can use the pilot tone to modulate the bias point of the amplifier as the signal is being amplified. As the amplifier bias current is controlled and modulated, the power dissipation is reduced, resulting in low cost and power efficient nodes. Herein, an optional digital predistortion functionality may be involved.

### Brief summary of the invention

Now, an improved arrangement has been developed to reduce the above-mentioned problems. As aspects of the invention, we present a network element of a cable television network, which is characterized in what will be presented in the independent claims.

The dependent claims disclose advantageous embodiments of the invention.

According to an aspect of the invention, there is provided a network element of a cable television (CATV) network, said network element comprising a distributed access node unit comprising a core network interface for receiving downstream signals; one or more amplifier units for amplifying downstream signal transmission for output into one or more output channels; a digital predistortion functionality for supplying a predistortion signal into an input of at least one of the amplifier units for correcting non-linearity of the amplifier unit, wherein a sampling signal for adjusting a level of the predistortion signal is obtained from a sampling point common with at least one other functionality of the network element requiring a sampling signal.

According to an embodiment, said sampling point locates in a downstream signal path between an amplifier stage and an output.

According to an embodiment, a test point of the network element is used as said sampling point.

According to an embodiment, said at least one other functionality of the network element requiring a sampling signal is an automatic gain control (AGC) unit or an automatic level and slope control (ALSC) unit. According to an embodiment, a sampling line from the sampling point to the AGC or ALSC unit is provided with a splitter for splitting the sampling signal to the digital predistortion functionality.

According to an embodiment, a sampling line from the sampling point to the AGC or ALSC unit is provided with a demultiplexer for demultiplexing the sampling signal to the digital predistortion functionality and to the AGC or ALSC unit.

These and other aspects, embodiments and advantages will be presented later in the detailed description of the invention.

### Brief description of the drawings

The invention will now be described in more detail in connection with preferred embodiments with reference to the appended drawings, in which:
- Fig. 1: shows the general structure of a typical HFC network; and
- Fig. 2: shows a simplified block chart of a network element according to an embodiment of the invention.

### Detailed description of the embodiments

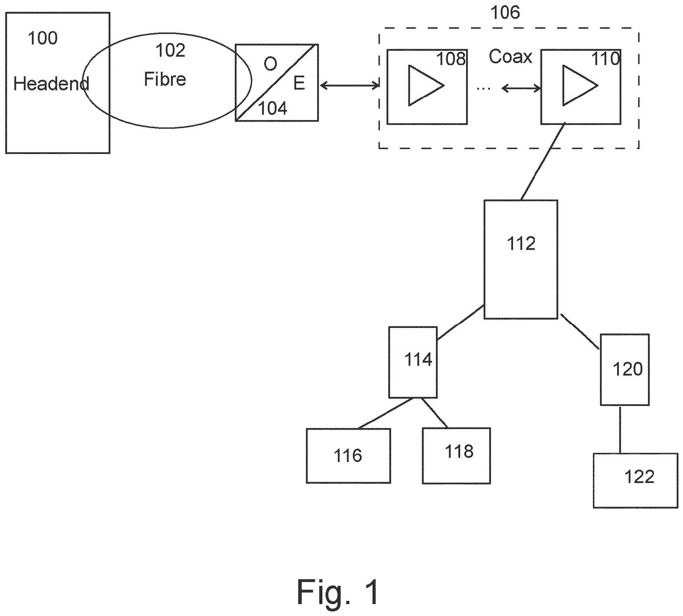

Figure 1 shows the general structure of a typical HFC network. Program services are introduced from the main amplifier 100 (a so-called headend) of the network via an optical fibre network 102 to a fibre node 104, which converts the optical signal to an electric signal to be relayed further in a coaxial cable network 106. Depending on the length, branching, topology, etc. of the coaxial cable network, this coaxial cable segment typically comprises one or more broadband amplifiers 108, 110 for amplifying program service signals in a heavily attenuating coaxial media. From the amplifier the program service signals are introduced to a cable network 112 of a smaller area, such as a distribution network of an apartment building, which are typically implemented as coaxial tree or star networks comprising signal splitters for distributing the program service signals to each customer. The cable network 112, such as the distribution network of an apartment, may further comprise a Network Interface Unit (NIU) arranged to divide downstream signals to appropriate home appliances. The NIU may operate as a home amplifier. From a wall outlet the signal is further relayed either via a cable modem 114 to a television receiver 116 or a computer 118, or via a so-called set-top box 120 to a television receiver 122.

Data Over Cable Service Interface Specification (DOCSIS) is a CATV standard providing specifications for high-bandwidth data transfer in an existing CATV system. DOCSIS may be employed to provide Internet access over existing hybrid fiber-coaxial (HFC) infrastructure of cable television operators. DOCSIS has been evolved through versions 1.0, 1.1, 2.0 and 3.0 to the latest version of 3.1. DOCSIS provides a lucrative option for cable network providers to maximize both the downstream and upstream data throughput using the existing cable TV network, but without making expensive changes to the HFC network infrastructure.

When implementing the HFC network of Figure 1 according to DOCSIS, the headend 100 of the CATV network comprises inputs for signals, such as TV signals and IP signals, a television signal modulator and a cable modem termination system (CMTS). The CMTS provides high-speed data services to customers thorough cable modems (CM; 114) locating in homes. The CMTS forms the interface to the IP-based network over the Internet. It modulates the data from the Internet for downstream transmission to homes and receives the upstream data from homes. The CMTS additionally manages the load balancing, error correction parameters and the class of service (CoS).

Signals from the headend 100 are distributed optically (fiber network 102) to the vicinity of individual homes, where the optical signals are converted to electrical signals at the terminating points 104. The electrical signals are then distributed to the various homes via the existing 75 ohm coaxial cables 106. The maximum data transfer of the coaxial cables is limited due to strong frequency-based attenuation. Therefore, the electrical signals transmitted over coaxial cables must be amplified. The amplifiers 108, 110 used for this purpose are suited to a specific frequency range. In addition, the upstream and downstream must occur over the same physical connection. The last part 112 of the coaxial connection between the CMTS and the CMs branches off in a star or a tree structure. A CMTS transmits the same data to all CMs located along the same section of cable (one-to-many communications). A request/grant mechanism exists between the CMTS and the CMs, meaning that a CM needing to transmit data must first send a request to the CMTS, after which it can transmit at the time assigned to it.

Depending on the version of DOCSIS used in the CATV network, there is a great variety in options available for configuring the network. For the downstream channel width, all versions of DOCSIS earlier than 3.1 use either 6 MHz channels (e.g. North America) or 8 MHz channels (so-called "EuroDOCSIS"). However, the upstream channel width may vary between 200 kHz and 3.2 MHz (versions 1.0/1.1), and even to 6.4 MHz (version 2.0). 64-QAM or 256-QAM modulation is used for downstream data in all versions, but upstream data uses QPSK or 16-level QAM (16-QAM) for DOCSIS 1.x, while QPSK, 8-QAM, 16-QAM, 32-QAM, 64-QAM and 128-QAM are used for DOCSIS 2.0 & 3.0.

DOCSIS 3.1 specifications support capacities of at least 10 Gbit/s downstream and 1 Gbit/s upstream using 4096 QAM. DOCSIS 3.1 rejects the 6 or 8 MHz wide channel spacing and uses narrower orthogonal frequency-division multiplexing (OFDM) subcarriers being 20 kHz to 50 kHz wide, which sub-carriers can be combined within a block spectrum of about 200 MHz wide.

DOCSIS 3.1 further provides the concept of Distributed CCAP Architecture (DCA). Converged Cable Access Platform (CCAP) may be defined as an access-side networking element or set of elements that combines the functionality of a CMTS with that of an Edge QAM (i.e. the modulation), providing high-density services to cable subscribers. Conventionally, the CCAP functionalities have been implemented in the headend/hub, such as the headend 100 in Figure 1. In a DCA, some features of the CCAP are distributed from headend/hub to the network elements closer to the customers, for example to the optical nodes 104 or the broadband amplifiers 108, 110 in Figure 1. DOCSIS 3.1 specifies at least two network element concepts, i.e. a Remote PHY Device (RPD) and a Remote-MACPHY Device (RMD), to which some functionalities of the headend can be distributed. A recent version of DOCSIS 3.1 specification also provided Annex F introducing a Full Duplex DOCSIS 3.1 technology, where a new distributed access node called Full Duplex (FDX) Node is determined.

One advantage obtained through the introduction of RPD/RMD units into the network elements is that it enables to use digital predistortion (DPD) algorithms also in said network elements. Said network elements, such as optical nodes comprise amplifier units, which almost as a default are characterized by at least some non-linearity. A DPD functionality may be implemented in the RPD/RMD or in the FDX, wherein the DPD functionality applies a predistortion (i.e. inverse distortion) into the input of the amplifier, thereby at least partly cancelling the non-linearity of the amplifier. Since the non-linearity of the amplifier typically varies depending on the operation mode, for example the non-linearity tends to increase as the output power of the amplifier increases towards the maximum output power. For compensating the variation in non-linearity, a sampling signal from the output of the amplifier is used as feedback for adjusting the level of DPD.

There are specific circuit components on the market for implementing the DPD functionality, and such component could be included in the network element comprising RPD/RMD or FDX unit. However, providing a separate sampling signal to the RPD/RMD or FDX for adjusting the level of DPD causes loss in signal sampling and decreases the output level of the amplifier.

Consequently, an improved arrangement is presented herein for providing feedback for adjusting the level of DPD in network elements.

According to an aspect, a network element of a cable television (CATV) network is now introduced, said network element comprising a distributed access node unit comprising a core network interface for receiving downstream signals; one or more amplifier units for amplifying downstream signal transmission for output into one or more output channels; a digital predistortion functionality for supplying a predistortion signal into an input of at least one of the amplifier units for correcting non-linearity of the amplifier unit, wherein a sampling signal for adjusting a level of the predistortion signal is obtained from a sampling point common with at least one other functionality of the network element requiring a sampling signal.

A typical network element of a cable television (CATV) network, such as an optical node, usually comprises one or more units, whose operation requires a sampling signal from the output of the network element in order to adjust the operation of said unit. Hence, instead of providing a separate sampling signal to the RPD/RMD or the FDX for adjusting the level of DPD, a sampling point common with at least one other unit requiring a sampling signal is used. Thus, no additional components for a sampling point and a sampling line are needed.

Consequently, no extra loss is caused by signal sampling and the output level of the amplifier remains substantially unaffected.

According to an embodiment, said sampling point locates in a downstream signal path between an amplifier stage and an output. Thus, for adjusting the level of the DPD correctly, the sampling signal is taken from the downstream signal path after the amplifier stage, but naturally before outputting the signal into an output channel.

According to an embodiment, said at least one other functionality of the network element requiring a sampling signal is an automatic gain control (AGC) unit or an automatic level and slope control (ALSC) unit. A network element of a cable television (CATV) network, such as an optical node or a broadband amplifier, typically comprises either an AGC unit or an ALSC unit. In a manner similar to the DPD, the operation of these units require a sampling signal from the output of the network element in order to adjust the operation of said units appropriately. Now the same sampling signal can be used for both the AGC/ALSC unit and the DPD functionality.

According to an embodiment, a sampling line from the sampling point to the AGC or ALSC unit is provided with a splitter for splitting the sampling signal to the digital predistortion functionality. In many network elements, the AGC or ALSC unit may be turned off. Thus, the sampling line from the sampling point to the AGC or ALSC unit may be provided with an inexpensive splitter for providing the sampling signal to the digital predistortion functionality independently whether the AGC or ALSC unit is on or off.

According to an embodiment, a sampling line from the sampling point to the AGC or ALSC unit is provided with a demultiplexer for demultiplexing the sampling signal to the digital predistortion functionality and to the AGC or ALSC unit. In some case, the operation of the AGC or ALSC unit requires that the AGC or ALSC unit is supplied with sampling signal at least periodically. Then the sampling line from the sampling point to the AGC or ALSC unit may be provided with a slightly more expensive demultiplexer for providing the sampling signal to the digital predistortion functionality and to the AGC or ALSC unit periodically.

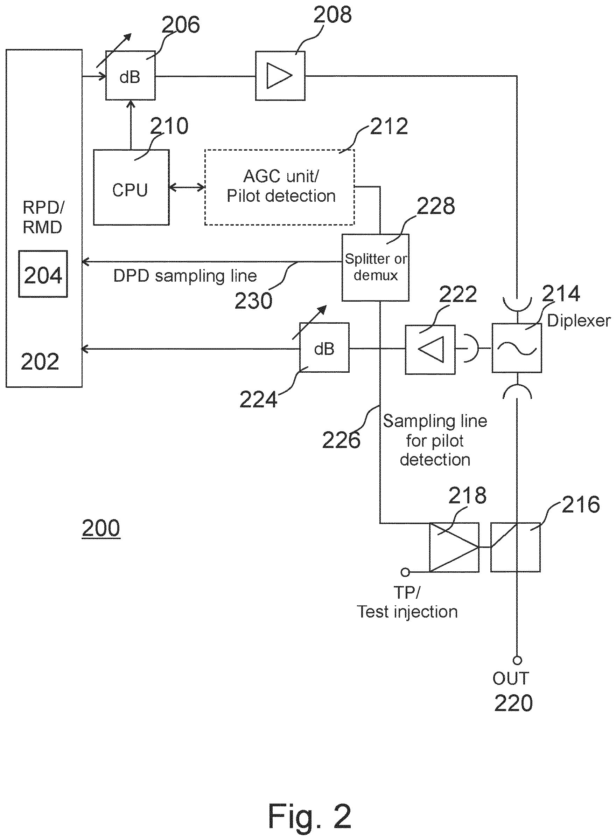

Figure 2 shows an example of a simplified block chart of network element according to an embodiment, the network element in this example being an optical node. Figure 2 shows a simplification of the node structure and therefore Figure 2 does not show all the functional blocks of a typical optical node.

The optical node 200 according to Figure 2 comprises a RPD/RMD module 202 arranged to receive digital downstream multiplexes from the headend via the optical interface 204 to the fiber network. The RPD/RMD module 202 generates the RF output signals by converting the digital signals to analog signals and modulating them accordingly. The RPD/RMD module 202 comprises its own processing unit for controlling the operation of the RPD/RMD module 202 and at least some of components of the optical node. The RPD/RMD module 202 also comprises the DPD functionality 204. The forward path (downstream) signals are supplied to an attenuator block 206, which operates as a sensitivity controller, and further to an amplifier 208. There may be a signal inclination controller (not shown) between the attenuator block 206 and the amplifier 208. Moreover, the optical node may comprise several combinations (not shown in Figure 2) of an attenuator, signal inclination controller and amplifier, by means of which the forward path signal is amplified, and on the other hand the signal levels are controlled into balance so that noise and distortion of the signal remain within allowed limits. The optical node comprises a processing unit 210, which controls the parameters of the above-mentioned blocks, for example, on the basis of control signal received from an AGC unit 212.

The amplified forward signal is supplied to a diplexer 214, and further via a directional coupler 216 to a tap for a test point 218 of the output signal. In order to input the forward signal further to the CATV network the optical node comprises at least one, but advantageously several output ports 220, to which the directional coupler 216 passes the forward path signal.

The reverse signal route comprises an amplifier 222 arranged after the diplexer 214 and an attenuator 224, via which the reverse path signal is supplied to the RPD/RMD unit.

The test point 218 may operate as the sampling point for the AGC unit or an ALSC unit, if used. Alternatively, the sampling point may provide sampling signal from downstream signal for a HMS/DOCSIS transponder. The sampling signal is supplied via a sampling line 226. The sampling line is provided with either a splitter or a demultiplexer 228, from which the split/demultiplexed sample signal is supplied via a DPD sampling line 230 to the RPD/RMD unit for adjusting the level of the DPD.

In general, the various embodiments may be implemented in hardware or special purpose circuits or any combination thereof. While various embodiments may be illustrated and described as block diagrams or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

A skilled person appreciates that any of the embodiments described above may be implemented as a combination with one or more of the other embodiments, unless there is explicitly or implicitly stated that certain embodiments are only alternatives to each other under the condition that the combination is within the scope of the invention as defined by the appended claims.

The various embodiments can be implemented with the help of computer program code that resides in a memory and causes the relevant apparatuses to carry out the invention. Thus, the implementation may include a computer readable storage medium stored with code thereon for use by an apparatus, such as the network element, which when executed by a processor, causes the apparatus to perform the various embodiments or a subset of them. Additionally or alternatively, the implementation may include a computer program embodied on a non-transitory computer readable medium, the computer program comprising instructions causing, when executed on at least one processor, at least one apparatus to apparatus to perform the various embodiments or a subset of them. For example, an apparatus may comprise circuitry and electronics for handling, receiving and transmitting data, computer program code in a memory, and a processor that, when running the computer program code, causes the apparatus to carry out the features of an embodiment.

It will be obvious for a person skilled in the art that with technological developments, the basic idea of the invention can be implemented in a variety of ways. Thus, the invention and its embodiments are not limited to the above-described examples but they may vary within the scope of the claims.

## Claims

1. A network element of a cable television (CATV) network, said network element (200) comprising
a distributed access node unit (202) comprising a core network interface for receiving downstream signals;
one or more amplifier units (208) for amplifying the downstream signals for output into one or more output channels;
a digital predistortion functionality (204) for supplying a predistorion signal into an input of at least one of the amplifier units for correcting non-linearity of the amplifier unit, **characterized in that**
a sampling signal for adjusting a level of the predistorion signal is obtained from a sampling point (218) common with at least one other functionality of the network element requiring a sampling signal, wherein said sampling point locates in a downstream signal path between said one or more amplifier units and an output (220) for said one or more output channels.

2. The network element according to claim 1, wherein a test point (218) of the network element is used as said sampling point.

3. The network element according to any preceding claim, wherein said at least one other functionality of the network element requiring a sampling signal is an automatic gain control (AGC) unit (212) or an automatic level and slope control (ALSC) unit.

4. The network element according to claim 3, wherein a sampling line (226) from the sampling point (218) to the AGC or ALSC unit (212) is provided with a splitter (228) for splitting the sampling signal to the digital predistortion functionality (204).

5. The network element according to claim 3, wherein a sampling line (226) from the sampling point (218) to the AGC or ALSC unit (212) is provided with a demultiplexer (228) for demultiplexing the sampling signal to the digital predistortion functionality (204) and to the AGC or ALSC unit (212).

## Patentansprüche

1. Netzelement eines Kabelfernsehnetzes (CATV-Netzes), wobei das Netzelement (200) Folgendes umfasst:
eine verteilte Zugangsknoteneinheit (202), die eine Kernnetzschnittstelle zum Empfangen von Abwärtssignalen umfasst;
eine oder mehrere Verstärkereinheiten (208) zum Verstärken der Abwärtssignale zur Ausgabe in einem oder mehreren Ausgangskanälen;
eine digitale Vorverzerrungsfunktionalität (204) zum Zuführen eines Vorverzerrungssignals in einen Eingang von zumindest einer der Verstärkereinheiten zum Korrigieren der Nichtlinearität der Verstärkereinheit, **dadurch gekennzeichnet, dass**
ein Messsignal zum Einstellen eines Pegels des Vorverzerrungssignals von einem Messpunkt (218) erhalten wird, der mit zumindest einer anderen Funktionalität des Netzelements, die ein Messsignal erfordert, gemeinsam ist, wobei sich der Messpunkt in einem Abwärtssignalweg zwischen der einen oder den mehreren Verstärkereinheiten und einem Ausgang (220) für den einen oder die mehreren Ausgangskanäle befindet.

2. Netzelement nach Anspruch 1, wobei ein Testpunkt (218) des Netzelements als der Messpunkt verwendet wird.

3. Netzelement nach einem der vorhergehenden Ansprüche, wobei die zumindest eine andere Funktionalität des Netzelements, die ein Messsignal erfordert, eine Einheit für die automatische Verstärkungsregelung (AGC) (212) oder eine Einheit für die automatische Pegel- und Steigungsregelung (ALSC) ist.

4. Netzelement nach Anspruch 3, wobei eine Messleitung (226) vom Messpunkt (218) zur AGC- oder ALSC-Einheit (212) mit einem Verteiler (228) zum Verteilen des Messsignals an die digitale Vorverzerrungsfunktionalität (204) versehen ist.

5. Netzelement nach Anspruch 3, wobei eine Messleitung (226) vom Messpunkt (218) zur AGC- oder ALSC-Einheit (212) mit einem Demultiplexer (228) zum Demultiplexieren des Messsignals an die digitale Vorverzerrungsfunktionalität (204) und an die AGC- oder ALSC-Einheit (212) versehen ist.

## Revendications

1. Élément de réseau d'un réseau de télévision par câble (CATV), ledit élément de réseau (200) comprenant
une unité de nœud d'accès distribué (202) comprenant une interface de réseau central pour recevoir des signaux en aval ;
une ou plusieurs unités d'amplification (208) pour amplifier les signaux en aval pour la sortie dans un ou plusieurs canaux de sortie ;
une fonctionnalité de prédistorsion numérique (204) pour fournir un signal de prédistorsion dans une entrée d'au moins l'une des unités d'amplification pour corriger la non-linéarité de l'unité d'amplification, **caractérisé en ce**
**qu'**un signal d'échantillonnage pour régler un niveau du signal de prédistorsion est obtenu à partir d'un point d'échantillonnage (218) commun avec au moins une autre fonctionnalité de l'élément de réseau nécessitant un signal d'échantillonnage, dans lequel ledit point d'échantillonnage se situe dans un trajet de signal en aval entre lesdites une ou plusieurs unités d'amplification et une sortie (220) pour lesdits un ou plusieurs canaux de sortie.

2. Élément de réseau selon la revendication 1, dans lequel un point de test (218) de l'élément de réseau est utilisé en tant que ledit point d'échantillonnage.

3. Élément de réseau selon une quelconque revendication précédente, dans lequel ladite au moins une autre fonctionnalité de l'élément de réseau nécessitant un signal d'échantillonnage est une unité de commande automatique de gain (AGC) (212) ou une unité de commande automatique de niveau et de pente (ALSC).

4. Élément de réseau selon la revendication 3, dans lequel une ligne d'échantillonnage (226) du point d'échantillonnage (218) à l'unité AGC ou ALSC (212) est pourvue d'un diviseur (228) pour diviser le signal d'échantillonnage vers la fonctionnalité de prédistorsion numérique (204).

5. Élément de réseau selon la revendication 3, dans lequel une ligne d'échantillonnage (226) du point d'échantillonnage (218) à l'unité AGC ou ALSC (212) est pourvue d'un démultiplexeur (228) pour démultiplexer le signal d'échantillonnage vers la fonctionnalité de prédistorsion numérique (204) et à l'unité AGC ou ALSC (212) .
